(19) Europäisches Patentamt
European Patent Office
Office européen des brevets

(11) EP 2 857 997 A1

(12) EUROPEAN PATENT APPLICATION
published in accordance with Art. 153(4) EPC

(43) Date of publication:
**08.04.2015 Bulletin 2015/15**

(21) Application number: **13800212.6**

(22) Date of filing: **09.05.2013**

(51) Int Cl.:
***G06F 17/50*** (2006.01) ***G06F 17/00*** (2006.01)
***H02G 13/00*** (2006.01)

(86) International application number:
**PCT/CN2013/075412**

(87) International publication number:
**WO 2013/181981 (12.12.2013 Gazette 2013/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.06.2012 CN 201210182588**

(71) Applicant: **Shanghai Goalie Software Development Co., Ltd.
Shanghai 201601 (CN)**

(72) Inventor: **Gao, Lei
Sijing Town, Songjiang District
Shanghai 201601 (CN)**

(74) Representative: **Glawe, Delfs, Moll Partnerschaft mbB von Patent- und Rechtsanwälten
Rothenbaumchaussee 58
20148 Hamburg (DE)**

# (54) METHOD FOR CALCULATING LIGHTNING FREQUENCY INTERCEPTION AREA OF CONSTRUCTION AND BUILDING UNDER CONSIDERATION OF SURROUNDING OBJECTS

(57) A method for calculating lightning stroke frequency interception area of a building and a method for calculating respective IA of several buildings in a certain region according to the method. The method comprises: performing measuring and mold establishing on TPB and surrounding objects, establishing virtual TPIB and TOIB in a three-dimensional space, distributing the overlapped IA S according to proportions of TPOV V1 and TOOV V2, acquiring the area of S1 part which belongs to TPB, and adding S1 to the exclusive IA S0 of TPB to obtain the IA of TPB under the consideration of surrounding objects; or dividing the region covering all the ISs into grids according to a certain size, respectively calculating heights h1 of TPIB and h2 of TOIB on each grid node, if h1 is higher than h2, adding the grid area into the IA of TPB, if h1 is lower than h2, performing no operation, and if h1 is identical to or substantially identical to h2, the point being a point on TISB, and drawing the point; processing each grid node sequentially in this way, a final accumulation value is obtained at last, which is just the IA of TPB; and the points on the boundary are drawn one by one, finally composing TISB. The method solves the problem of calculating lightning stroke frequency interception area of a building under consideration of surrounding objects.

EP 2 857 997 A1

## Description

Background of the Present Invention

### Field of Invention

The present inventive patent is a method for quantitative calculating lightning stroke frequency interception area of a building (including structure, for simplicity, hereinafter collectively called as building) under consideration of surrounding objects (which may be buildings, structures or any other facilities or arrangements higher above the ground and having fixed locations), which is useful for the lightning protection industry, and for those related units, e.g., Engineering and Building Designing Institute, lightning prevention centre of Weather Bureau of each province, lightning protection companies, lightning protection offices, to carry out lightning risk assessment, design, acceptance and detection of lightning protection device for buildings.

### Description of Related Arts

Lightning stroke is a common natural disaster threatening the safety of buildings and humans. It requires for an estimation of annual lightning stroke frequency upon a building when one carries out lightning risk assessment, lightning protection design, and acceptance and detection of lightning protection device of the building, so as to reasonably classify its lightning protections level. According to the provision of the PRC standard GB50057-2010 "Design code for lighting protection of buildings" (hereinafter referred to as GB50057) implemented on October 1, 2011, the formula is showed below:

$$N = k \times Ng \times Ae \qquad \text{(formula 1)}$$

In formula 1, N is an estimation of the annual number of lightning stroke to a building (unit: times/year); K is a correction factor, and generally is 1, without a numerical unit. Ng is the number of lightning strokes per square kilometer per year happened in the location of buildings, with a unit of times/square kilometer/year; it is generally converted according to a local number of thunderstorm day (according to GB50057, the conversion formula is that: $Ng = 0.1 \times Td$, wherein, Td is a local annual average number of thunderstorm day) or obtained by the detection data according to the local lighting locating system. Ae is an equivalent area (hereinafter referred to as interception area (IA)) of the ground scope intercepting the same lightning stroke frequency (hereinafter referred to as interception scope (IS)) of the building, with a unit of square kilometer.

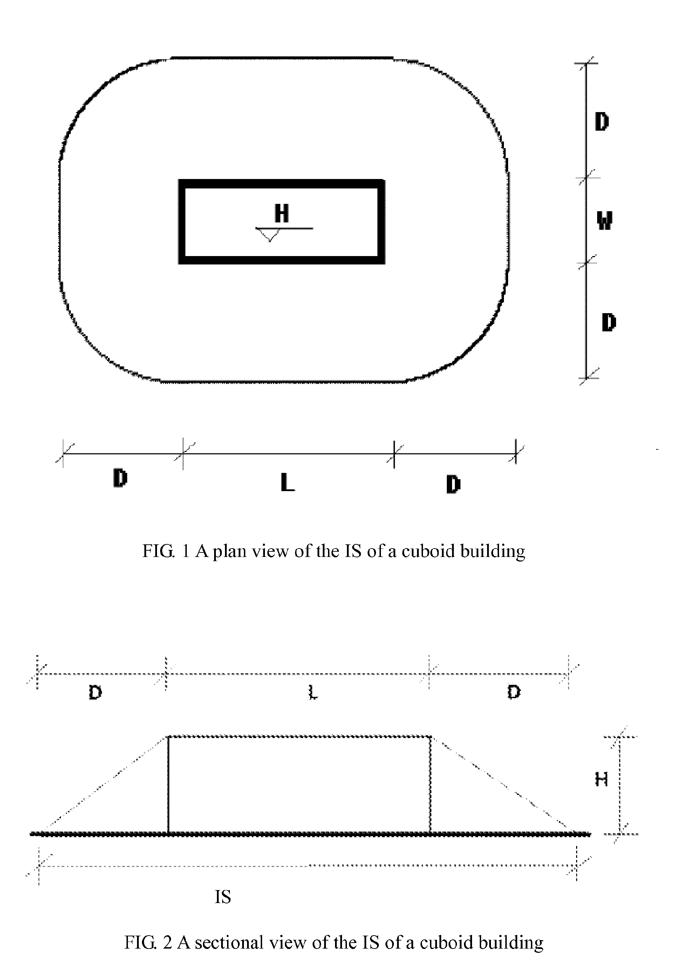

In generally, the two parameters, k and Ng, are relatively easy to determine, while the calculation process for Ae is relatively complicated. In the "Appendix A Estimation of annual lightning stroke frequency of a building" of the GB50057, it is stipulated that the equivalent area intercepting the same lightning stroke frequency of a building should be the area which is enlarged outward of its actual occupied area; as for a cuboid-shaped building, as shown in figure 1, its plan view of the IS on the ground is a rectangle with the four corners of circular bead. The rounded rectangle has a length of L+2D, a width of W+2D, and four fillet radius of D; its IA is calculated by the following formula:

$$Ae = [L \times W + 2(L+W) \times D + \pi D^2] \times 10^{-6} \qquad \text{(formula 2)}$$

In formula 2: L, W, D respectively refers to the length, width, and enlarged width (EW) of a cuboid building (unit: meter).

The EW D of a building, refers to the distance between the edge of the building and the edge of its IS, which depends on the height H (unit: meter) of the building. When the height H of the building is less than 100 meters, D is obtained by the following formula:

$$D = [H \times (200-H)]^{1/2} \qquad \text{(formula 3)}$$

When the height H of the building is equal to or larger than 100 meters, D is obtained by the following formula:

$$D=H \qquad \text{(formula 4)}$$

The above are the provision in GB50057. In different standards or norms, the definitions of EW and IA are varied. For example, in GB21714.2-2008 "Lightning protection, part 2: Risk Management", it is stipulated that regardless of how high the building is, the value of the EW is taken as three times of the height, i.e., D is obtained by the following formula:

$$D=3H \qquad \text{(formula 5)}$$

Correspondingly, in GB21714, IA is represented by Ad.

The different definitions of EW and IA have no effect on the independence and integrity of the present inventive patent. No matter which standard or norm is used to calculate the IA of a building, the basic principle of the present inventive patent is the same, but applying the corresponding formula of its EW of D.

To sum up, an IA of a cuboid-shaped building is calculated according to formula 2, with a plan view of its IS as shown in figure 1. GB50057 also stipulates that, "when a building features a varied of height of different parts, the maximum EW should be calculated point-by-point along the periphery of the building, and its equivalent area should be the encircling area by linking lines by outer ends of the largest EW of each point". Thus, if the periphery of the top surface of the building and its periphery of the IS are linked, the shape of the IS within a three-dimensional space can be obtained, as shown in figure 2, which is shown to a sectional view of an IS of a cuboid-shaped building.

The above describes a method for calculating an IA of an isolated building having no other objects around, but actually a building rarely exists alone. In the modem city, buildings are highly intensive, and the ISs of those adjacent buildings will be affected by one another, as a result, in the "Appendix A Estimation of annual lightning stroke frequency of a building" of the GB50057, it also stipulates a calculating method for correcting the IA of the present building, when there are other buildings around, e.g., it is stipulated in item 3 that: "as the building is lower than 100 meters, and there are other higher buildings within the peripheral range of its 2D as well,... the equivalent area can be calculated by subtracting D×(the total length of all parallel side lengths of these buildings and those considered buildings in meters) $\times 10^{-6}$ ($km^2$)"; and it is stipulated in item 5 that: "as the building is equal to or higher than 100 meters, and there are other buildings having the same or less height within the peripheral range of its 2H, and without the protection range that the determined building is equal to the height (m) of the building in the form of ball radius,... the equivalent area can be calculated by subtracting (H/2) × (the total length of all parallel side lengths of these buildings and those considered buildings in meters) $\times 10^{-6}$ ($km^2$)", etc.

Though these calculation methods are given in GB50057, the definition is not clear enough, and the stipulation is not specific enough as well. For example, it stipulates that, "as those buildings are not within the protection scope of the considered buildings...", then how to determine that whether a building is located within the protection scope of another building? If a part of the building is located within the protection scope of the considered buildings, then how to calculate? For another example, a calculation parameter is frequently mentioned in GB50057 that "the total length of all parallel side lengths of these buildings and those considered buildings in meters", but as for a circular building or a building that is not parallel with the considered building, then how to calculate? No specific definition or stipulation is made in GB50057 for those situations.

Meanwhile, the calculation methods given in GB50057 are inadequately considered for a variety of complicated situations, such as: where the difference between the present building and other building in height merely features two options that "same with or less than" and "higher than". No matter how higher it is, there is just one option that "higher than", and the obtained calculation results are the same. As for the difference of distance between the present building and other building, there are merely two options that "within the range of 2D" and "within the range of 2H"; as long as it is within such range, no matter how far it is, the calculation results are the same. Apparently, the calculation results of same height are unable to reflect the wide variety of height and distance among different buildings.

Moreover, the calculation methods given in GB50057, greatly require human to determine and select different items, formulas and corresponding parameters, while in the case of a large number of buildings with complicated shapes, the probability of error is large.

In short, the calculation methods given in GB50057 are given from the qualitative viewpoint, and are not conducive for the establishment of mathematical model, and feature difficulty in operation, high error probability, poor calculation accuracy, and actually is unable to meet the requirement of daily work in reality.

In such situation, by studying, GAO Lei provides a method for calculating lightning stroke frequency interception area of a building under consideration of surrounding objects scientifically and reasonably. The method is given from a quantitative viewpoint, and is easy for calculation by establishing mathematical model. According to developed software by this method, once the user completes the measurement and model establishment of the present building and the surrounding buildings, the remaining calculations can be done automatically by the software, which is convenient for use, and the calculation results are accurate as well.

**Summary of the Present Invention**

Buildings are rarely alone, and for most buildings, there more or less exists other buildings or structures around, and the interception scopes (ISs) of them would overlap to some extent (by using a concept of mathematics, the ISs of different buildings have intersections.); as a result, when one calculates an interception area (IA) of a building (hereinafter referred to as the present building (TPB)), the calculation result is undoubtedly unscientific if its surrounding buildings are not taken into consideration. So, when considering its surrounding buildings, it is an issue that how to calculate lightning stroke frequency interception area (IS) of TPB.

From figure 2, it can be seen that, an IS of a building is the encircling scope by linking lines by outer ends of each points at the periphery of the tops surface of the building outward with an EW, as a result, one should consider the effect of the surrounding objects on the lightning stroke frequency interception scope of TPB from a three-dimensional viewpoint.

To be specific, for TPB, project each point (referred to as the present point (PP), with a height assumed to be *H*) on the peripheral edges of its top surface (which top surface may be horizontal or slope surface, and a building may have a number of top surfaces) to the surrounding ground according to its own EW *D* (*D* is determined by *H*, and might feature varied specific definitions in various standards or provisions), so as to obtain a respective circular projection region of each PP which is located on the ground. For adjacent points, the projection regions may be overlapped (i.e., have intersection).

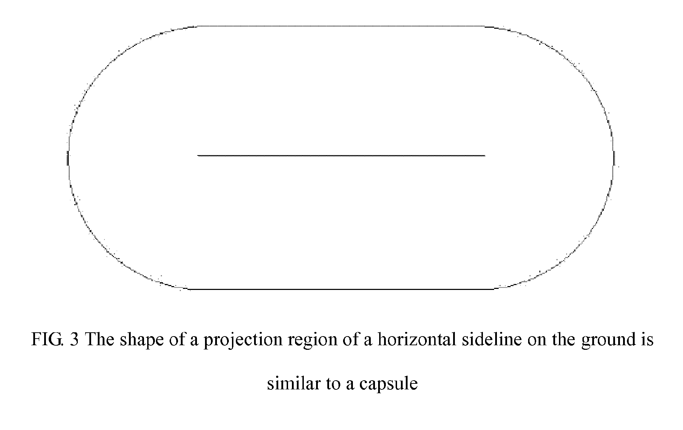

Similarly, one can project each sideline at the peripheral edges of the top surface to the surrounding ground according to its own EW D. The essence of that is to integrate the projection region of each PP on the sideline, to obtain the projection region of the sideline. The integration refers to that, if one point on the ground locates within the projection region of any PP on the sideline, the point should be considered being located within the projection region of the sideline; accordingly, the projection region of the sideline is obtained (by using a concept of mathematics, the projection region of the sideline may be understood as an union set of the projection region of each PP). If the sideline is horizontal, the shape of the projection region on the ground is similar to a capsule, as shown in Figure 3.

Similarly, one can also project the whole top surface to the surrounding ground according to its own EW *D*. Its essence is to integrate the projection region of each sideline of the top surface and vertical projection of the top surface itself on the ground, while the specific shapes of the obtained projection region vary over the shape and the height of a top surface.

By integrating the individual projection region of each top surface of TPB, the obtained whole projection region is an IS of TPB on the ground, which is called the present interception scope (TPIS), and its area is the IA of TPB, which is called the present interception area.

In a three-dimensional space, there exists a virtual space body, which is composed by top surfaces and the IS of TPB and line segments projecting from the top surfaces to the IS. This space body is called the present interception body (TPIB).

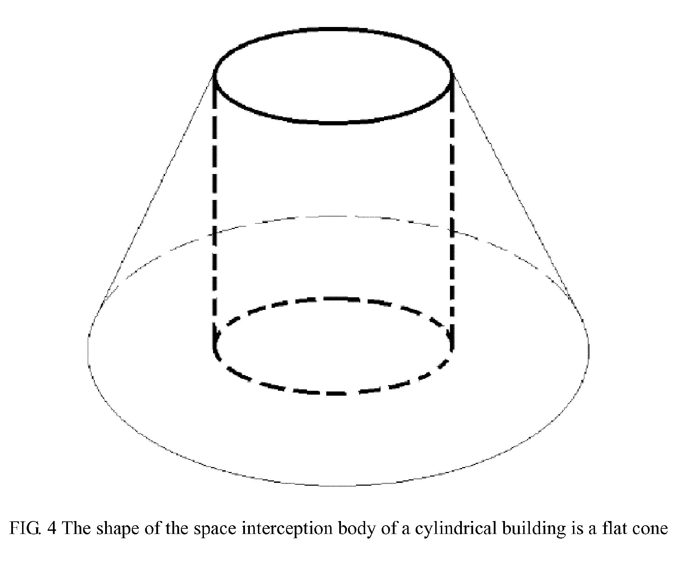

To be specific, TPIB is encircled by a top surface (i.e., each top surface of TPB, which may be horizontal, or inclined, or even vertical, such as a outer wall connecting the bilevel roofs of the rooftop), a bottom surface (i.e., the IS of TPB on the ground) and a side face (the side face consists of the projection lines at the outmost and links the periphery of the top surface and the periphery of the bottom surface together); wherein the side face is generally combined by conical surfaces and slope surfaces. For example, as for a space interception body of a cylindrical building, the top surface is circular, the bottom surface is circular as well, the side face is a taper surface of full 360 degree, and the whole shape is a flat conoid, as shown in figure 4. As for a space interception body of a cuboid building, the top surface is a rectangle, the bottom surface is a rounded rectangle as shown in figure 1, the side face is together formed by four slope surfaces (upper sides of the four slope surfaces are respectively two long sides and two short sides of the rectangle) and four taper surfaces with corners of 90 degree (vertexes of the four taper surfaces are respectively corresponded to four vertexes of the rectangle), and the whole shape is similar to a bridge abutment.

The processing principle of the side face is that: side faces are always located at the outermost and at the upper side. That means: in the case that side faces and top surfaces intersect one another, the side faces at the outermost and at the upper side are the side faces of the whole space interception body, while the side faces at the inner side and at the lower side are wrapped inside the space interception body, and are no longer considered as the side face. For building tops with a large inclination or located at a relative lower position (for example, the roof of annex buildings of a tall building), the whole or a part of the top surfaces may be wrapped inside the space interception body and no longer be considered as the top surface.

The above is the process of establishing TPIB.

According to the above method, one can perform the same process on each other building around TPB, to obtain their own space interception body. The distant other building can be disregarded, if its IS on the ground does not overlap with that of TPB. Therefore, the so-called the other buildings (TOBs) herein, are just those buildings having influence on the IA of TPB. There may be more than one TOB, which are distributed around TPB.

The different definitions of EW *D* may affect the number of TOBs. Undoubtedly, when defining the EW by using formula 5, the number of TOBs will be larger than that is defined by using formula 4.

After the other building (TOB) is determined, the individual space interception body of each TOB is integrated to form an integration (the union set of each space interception body), which is called the other interception body (TOIB), and its IS is called the other interception scope (TOIS). The meaning of the integration herein is that: if a space point is located within the interception body (IB) of any TOB, then it is a point belongs to TOIB, and thus TOIB is obtained. Since there may be more than one TOB which are distributed around TPB, the shape of TOIB may be complicated and even unconnected. However, same with TPIB, TOIB is encircled by top surfaces, bottom surfaces and side faces, wherein, the side face is generally combined by taper surfaces and slope surfaces, and the side face or the top surface may intersect one another, by this time, the outermost and the upper sides become the side face of the whole space interception body.

TPIB and TOIB are obtained above. Hereinafter, the IA of TPB will be calculated accordingly.

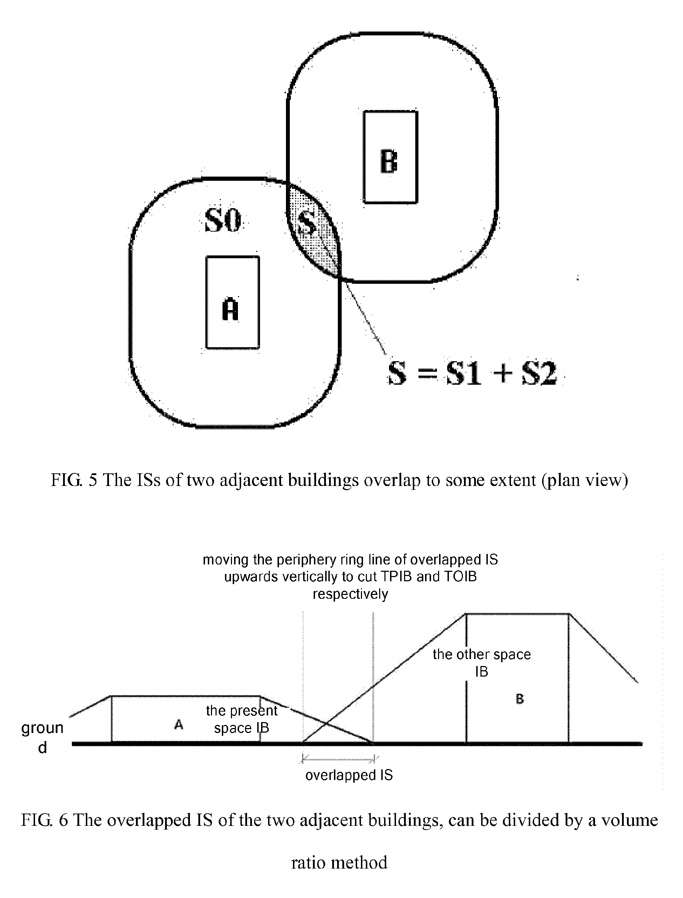

Figure 5 is the plan view of the ISs of two adjacent buildings, wherein, A is TPB, B is TOB, and the ISs of those two buildings overlap, and the shadow region in figure is the intersection of TPIS and TOIS. Accordingly, the IS of TPB can be divided into two parts: one part is exclusive to TPB, and has no overlap with the IS of TOB, and the area of such part is labeled as S0; the other part has overlap with the IS of TOB, and is called the overlapped IS, and the area of such part is labeled as S. The S0 and S are calculable by the knowledge of plane geometry and calculus.

In some special cases, S0 or S may be zero. For example, if TPB is relative low, while TOB is relative high, and both are very close as well, at this time, TPIS is completely located within TOIS (being its subset), then S0 is zero. If TPB is isolated (there is no other building around), at this time, there are no intersection between TPIS and TOIS, then S is zero. Even under such cases, the calculation method of the present patent is still available.

Since the overlapped IS is shared by TPB and TOB, then if S is larger than zero, the area of S can be divided into two parts, S1 and S2, in which S1 belongs to TPB and S2 belongs to TOB.

As shown in figure 5, S=S1 +S2, thus the keypoint of the problem is how to calculate the size of S1.

There are two methods for calculating S1, which will be introduced respectively as follows:

First method, which is called volume-quantitative method

The periphery ring line of the overlapped IS moves upwards vertically to cut TPIB and TOIB respectively, as shown in figure 6, thus the respective part of both IBs located within the overlapped IS can be obtained, which volume are called the present overlapped volume (TPOV) V1 and the other overlapped volume (TOOV) V2, respectively. The volumes of V1 and V2 are calculable by the knowledge of solid geometry and calculus. S1 can be obtained according to V1, V2 and S, with the specific formula as follows:

$$S1 = S \times V1 / (V1 + V2)$$

The volume-quantitative method is scientific and reasonable, and is our key recommended method. However, such method has a small disadvantage that: since S is calculated by a quantitative method, it is unable to clearly divide the boundary between TPIS and TOIS. Accordingly, the following method can be used to supplement.

Second method, which is called height-qualitative method

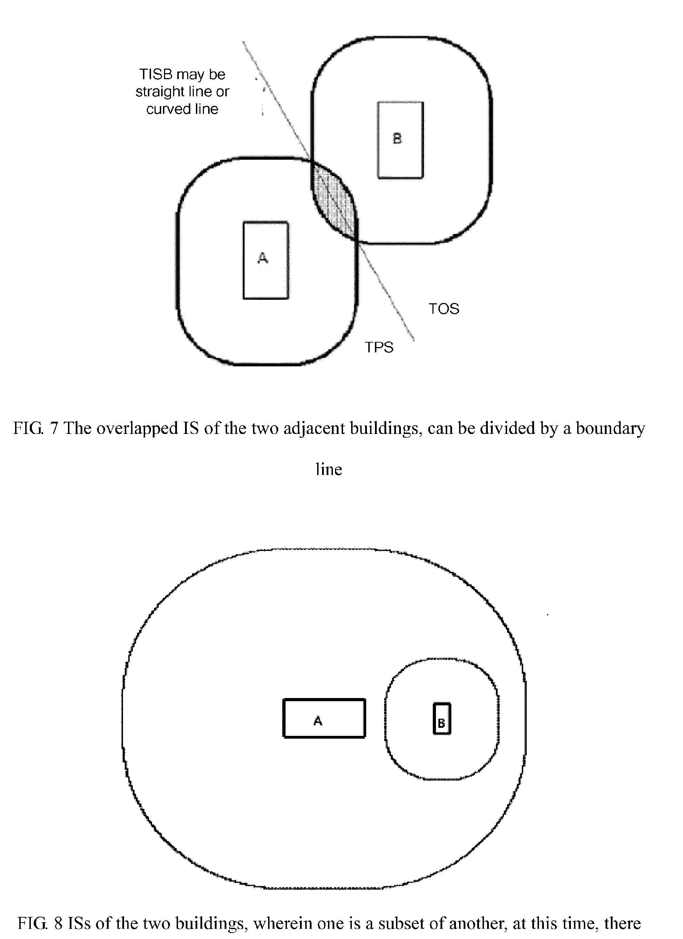

Since TPIB and TOIB have an intersection, a boundary line could be drawn between them, which is called the interception scope boundary (TISB), with its two sides being called as the present side (TPS) and the other side (TOS), respectively. TPS is close to TPB, and TOS is close to TOB, as shown in figure 7. On the other hand, if there is no intersection between TPIB and TOIB, the boundary line is an obvious separate belt, in which the height of the interception body will be zero.

The definition of TISB is that: for any point of TPS of the boundary, the height of TPIB at such point is no lower than the height of TOIB at such point; for any point of TOS of the boundary, the height of TOIB at such point is no lower than the height of TPIB at such point; for any point on the boundary, TPIB and TOIB features same height at such point. According to such definition, the boundary may be straight line, curved line, or other forms. The overlapped IS is divided into two parts by TISB, with the area of the part at TPS being S1, and the area of the part at TOS being S2, as shown in figure 7.

According to the above definition, one can draw the boundary line, and calculate S1 and S2 as well. To be specific, the overlapped IS is divided into grids according to a certain size, then respectively calculate the height of TPIB (h1) and the height of TOIB (h2) at each grid node. According to the height difference between h1 and h2, the process is listed respectively as follows:

If h1 is higher than h2, the node position is located at TPS of the boundary, and the grid area is counted into S1;

If h1 is lower than h2, the node position is located at TOS of the boundary, and the grid area is counted into S2;

If h1 is identical to or substantially identical to h2, the point is the point at TISB, and the point need to be drawn;

After processing each grid node sequentially in this way, final accumulation values of S1 and S2 are obtained; and the points on the boundary are drawn sequentially to form TISB finally.

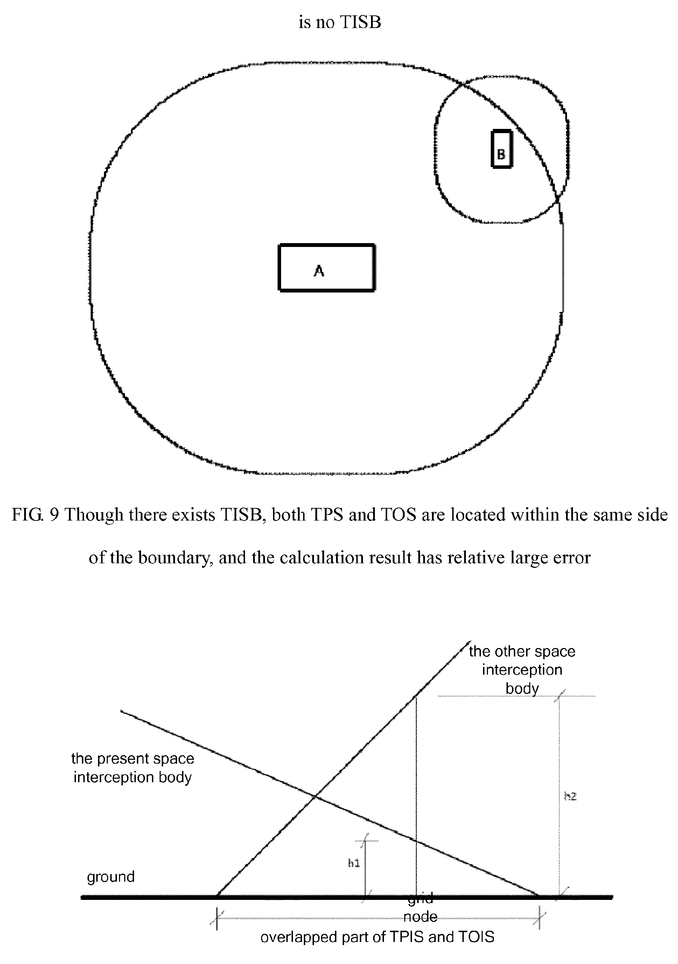

Generally, the calculation result by using the height-qualitative method is the same with that by using the volume-quantitative method. Furthermore, the height-qualitative method may clearly draw a boundary line between TPIS and TOIS, and be convenient to showcase the specific IS of a building. However, in some special cases, the height-qualitative method has problems, such as, if two buildings have relative large height difference, and are close together, and the IS of the lower building is a subset of the IS of the higher building, as shown in figure 8, at this time, TISB would not exist, and the height-qualitative method is unavailable; or, though TISB exists, but both TPS and TOS locate at the same side of the boundary line, as shown in figure 9, at this time, the error of the calculation result would be relative large. Therefore, the height-qualitative method is not recommended, unless there is a need to draw the boundary line between TPIS and TOIS on the premise that the calculation result is guaranteed to be correct.

S1 can be obtained by the above two methods (the volume-quantitative method or the height-qualitative method). Finally, by adding S0 to S1, it is the lightning stroke frequency interception area of a building under consideration of surrounding objects

The above is the main content of the present inventive patent.

**Brief Description of the Drawings**

Figure 1: A plan view of a cuboid building and its IS on the ground. The rectangle in the middle is the cuboid building itself, with a length of L, a width of W, a height of H. The rounded rectangle outside is its IS, with a length of L+2D, a width of W+2D, four fillets radius of D. D is the EW, which depends on H. Note that the whole region surrounded by the rounded rectangle, including the rectangular projection region of the building itself on the ground, is the IS.

Figure 2: A sectional view of the IS of a cuboid building with a length of L, a height of H. Projecting from the edge of the top surface towards to the outward ground with EW D, the length of the IS is L+2D.

Figure 3: A plan view of the projection region of a horizontal sideline on the ground, with a shape of round rectangle, which is similar to a capsule.

Figure 4: A perspective view of a cylindrical building and its interception body. The cylinder inside is the building itself, and the flat cone outside is its space interception body.

Figure 5: A plan view of two adjacent buildings and their ISs on the ground, wherein A is TPB, B is TOB, S0 is the exclusive IS of TPB, and the shadow, with an area of S, is the overlapped IS (intersection part) shared by two buildings. S consists of S1 and S2. S1 and S2 are the respective IA of TPB and TOB in the overlapped IS.

Figure 6: A sectional view of calculating S1 and S2 of two adjacent buildings according to a volume-quantitative method. Since the space interception bodies of the two buildings overlap, the periphery ring line of the overlapped IS could be moved upwards vertically to cut TPIB and TOIB respectively, to get V1 and V2. Then S1 and S2 can be calculated according to the ratio of V1 to V2.

Figure 7: A plan view of calculating S1 and S2 of two adjacent buildings by a height-qualitative method, wherein A is TPB, B is TOB, and the overlapped IS is divided into two parts by a boundary line, with areas of S 1 and S2 respectively. The whole IS is divided into TPS and TOS by the boundary line. In TPS, TPIB is no lower than TOIB at any point; in TOS, TOIB is no lower than TPIB at any point; on the boundary, TPIB has the same height with TOIB; the boundary may be straight line or curved line.

Figure 8: A plan view of a special case which could not be calculated by the height-qualitative method, wherein A is much higher than B, and the two buildings are close to each other. The IS of B is completely located within the IS of A (being its subset), at this time, TISB is unavailable and it is impossible to calculate the IA by the height-qualitative method.

Figure 9: A plan view of a special case which has relative large calculation error by the height-qualitative method. In the figure, though there exists TISB, both TPS and TOS are at the same side of the boundary, so that the result calculated by the height-qualitative method has relative large error.

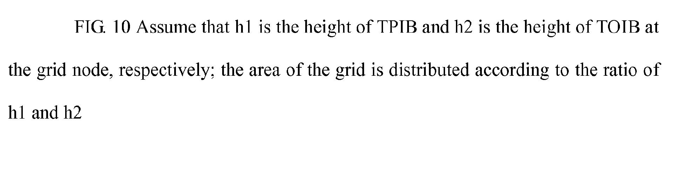

Figure 10 is a sectional view of an operation of a certain grid node, in the figure, TPB is located at the left side of the figure, and TOB is located at the right side of the figure; h1 and h2 are the height of TPIB and TOIB at the grid node, respectively; the area of this grid node is distributed according to the ratio of h1 and h2.

## Detailed Description of the Preferred Embodiments

Generally, the shape of a space interception body is relative complicated, and it is impossible to obtain accurate S0, S, V1 and V2 by a way of hand calculation, thus it is preferred to calculate by using computer programming. Though the principle is the same, both the manner and process of a specific programming may be varied according to personal habits. Hereinafter, a simplest embodiment is list, which comprises the following steps:

Step 1: measuring TPB and TOB surrounded, to acquire the related information of direction, shape, size, height and the like, which are inputted into a computer by modeling. If it is unclear whether a building is TOB, one should input the surrounding buildings as many as possible, that is the wider the region is, the better it is.

Step 2: by using computer programming, the whole region including the IS of all buildings is divided into grids according to a certain size, and the height of each grid node of TPIB and TOIB is calculated and is stored into a multi-dimensional array; the array at least has three dimensions, wherein the two dimensions are used to represent plane coordinates, and the other dimension is used to represent a height of a space interception body on the coordinate point; the more finer the divided grid is, the more the number of the grids is, the larger the scale of the array is, the more accurate the calculation result is, and the longer time the calculation needs as well.

Step 3: by using computer programming, scanning each grid node in the whole region, to respectively acquire the height h1 of TPIB and h2 of TOIB at this point, as shown in figure 10; based on whether the height of h1 is zero, it can be divided into the following two cases for processing:

If h1 is zero, performing no operation;

If h1 is larger than zero, h1/(h1+h2) of such grid area is accumulated into the IA of TPB, such as: assume that h1=3 m, h2=7 m, then 30% (i.e., 3/10) of the grid area is added; assume that h2=0, then 100% of the grid area is added.

Step 4: performing the process on the area of each grid of the whole region in this way, the accumulative value is finally obtained, that is the lightning stroke frequency interception area of TPB under consideration of surrounding objects.

## Claims

1. A method for quantitative calculating lightning stroke frequency interception area of a building (or a structure), comprising a process performing measuring and mold establishing on TPB and surrounding objects (building or structure), **characterized in that**, establishing virtual TPIB and TOIB in a three-dimensional space, distributing an overlapped IA S according to ratio of TPOV V1 and TOOV V2, acquiring the area S1 of the part which belongs to TPB in the overlapped IA, and adding that to the exclusive IA S0 of TPB to obtain the IA of TPB under the consideration of surrounding objects.

2. The method according to claim 1, **characterized in that**, establishing the interception body respectively for each other objects, which surround TPB and may affect the IA of TPB, and integrate them together as a whole (i.e., a union set of the space interception bodies of all the other objects) to obtain TOIB, to calculate the IA of TPB.

3. The method according to claim 1, **characterized in that**, established TPIB and TOIB are respectively encircled by a top surface, a bottom surface and a side face, and the top surface is the top surface of the building, the bottom surface is the IS of the building on the ground, the side face links the periphery of the top surface and the periphery of the bottom surface, and is combined by two forms: taper surface and slope surface; when two side faces or a side face and a top surface intersect, the side faces at the outermost and at the upper side are considered as the side face of the whole space interception body, while the side faces at the inner side and at the lower side are wrapped inside the space interception body, and are no longer considered as the side face or the top surface.

4. The method according to claim 1, **characterized in that**, an overlapped IA S shared by TPB and TOB is distributed, to obtain the area of S1 part which belongs to TPB; the specific method is that, the periphery ring line of overlapped IS is moved upwards vertically to cut TPIB and TOIB, to respectively obtain TPOV V1 and TOOV V2, accordingly, S1 is obtained by the formula that: $S1 = S \times V1 / (V1 + V2)$.

5. The method according to claim 1, **characterized in that**, established TPIB or TOIB is stored and calculated in a form of multi-dimensional array, the specific method is that, the whole region including the ISs of all buildings is divided into grids according to a certain size, and the height of TPIB and TOIB at each grid node is calculated and is stored into a multi-dimensional array; the array at least has three dimensions, wherein the two dimensions are used to represent plane coordinates, and the other dimension is used to represent the height of the space interception body on the coordinate point.

6. The method according to claim 1, **characterized in that**, a plane region including the whole IS is divided into grids, and the size of the grids may vary in a certain range, and the related information of each node is determined by the height h1 of TPIB and h2 of TOIB at each grid node: at this node position, if h1=0, h2=0, then the point does not belong to any IS; if h1>0, h2=0, then the point is located and is only located within TPIS; if h1=0, h2>0, then the point is located and is only located within TOIS; if h1>0, h2>0, then the point is located within the overlapped IS shared by TPB and TOB; if h1 is identical to or substantially identical to h2, then the point is located at the boundary between TPIS and TOIS.

7. The method according to claim 1, **characterized in that**, the overlapped IS shared by TPB and TOB is divided into grids, with the size of the grids may vary in a certain range, to respectively obtain the height h1 of TPIB and h2 of TOIB at each grid node; if h1 is larger than zero, h1/(h1+h2) part of such grid area is added to the IA of TPB; performing the process on each grid, the final obtained accumulative value is the area of S1 part, which belongs to TPB, in the overlapped IS.

8. The method according to claim 1, **characterized in that**, a plane region covering all the ISs is divided into grids, with the size of the grids may vary in a certain range, to respectively obtain the height h1 of TPIB and h2 of TOIB at each grid node; if h1 is equal to zero, then skip this node, otherwise the h1/(h1+h2) part of such grid area is accumulated in the IA of TPB; performing the process on each grid, the final obtained accumulative value is the lightning stroke frequency interception area of TPB under consideration of surrounding objects.

9. A method for calculating each IA of several buildings within a certain region according to the method in claim 1, **characterized in that**, each time assigning a building therein as TPB, to calculate and obtain the IA under consideration of surrounding objects; sequentially performing the process on each building in the region, to finally obtain the IA of each building.

10. A method for calculating lightning stroke frequency interception area of a building (or structure), comprising performing measuring and mold establishing on TPB and surrounding objects (building or structure), **characterized in that**, establishing virtual TPIB and TOIB in a three-dimensional space, dividing the area where all the ISs locate into grids according to a certain size, respectively calculating heights h1 of TPIB and h2 of TOIB on each grid node; according to the height difference between h1 and h2, respectively performing the process that:

   if h1 is higher than h2, adding the grid area into the IA of TPB;
   if h1 is lower than h2, performing no operation;
   if h1 is identical to or substantially identical to h2, the point being a point on TISB, and drawing the point;
   processing each grid node sequentially in this way, a final accumulation value is obtained at last, which is just the IA of TPB; and the points on the boundary are drawn one by one, finally composing TISB.

H
D
W
D
D
L
D

FIG. 1 A plan view of the IS of a cuboid building

D
L
D
H
IS

FIG. 2 A sectional view of the IS of a cuboid building

FIG. 3 The shape of a projection region of a horizontal sideline on the ground is similar to a capsule

FIG. 4 The shape of the space interception body of a cylindrical building is a flat cone

B
S0
S
A
S = S1 + S2

FIG. 5 The ISs of two adjacent buildings overlap to some extent (plan view)

moving the periphery ring line of overlapped IS upwards vertically to cut TPIB and TOIB respectively
the other space IB
B
the present space IB
A
groun d
overlapped IS

FIG. 6 The overlapped IS of the two adjacent buildings, can be divided by a volume ratio method

TISB may be
straight line or
curved line
B
A
TOS
TPS

FIG. 7 The overlapped IS of the two adjacent buildings, can be divided by a boundary line

A
B

FIG. 8 ISs of the two buildings, wherein one is a subset of another, at this time, there

is no TISB

B
A

FIG. 9 Though there exists TISB, both TPS and TOS are located within the same side of the boundary, and the calculation result has relative large error

the other space interception body
the present space interception body
h2
h1
ground
grid node
overlapped part of TPIS and TOIS

FIG. 10 Assume that h1 is the height of TPIB and h2 is the height of TOIB at the grid node, respectively; the area of the grid is distributed according to the ratio of h1 and h2

# INTERNATIONAL SEARCH REPORT

International application No.
PCT/CN2013/075412

**A. CLASSIFICATION OF SUBJECT MATTER**

See the extra sheet

According to International Patent Classification (IPC) or to both national classification and IPC

B. FIELDS SEARCHED

Minimum documentation searched (classification system followed by classification symbols)

IPC: G06F 17/-; G06F 3/-; H02G13/-; H02G 7/-

Documentation searched other than minimum documentation to the extent that such documents are included in the fields searched

Electronic data base consulted during the international search (name of data base and, where practicable, search terms used)

CNPAT, CNKI, WPI, EPODOC: strike, stroke, light, thunder, time, number, area, intercept, equivalent, overlap, height, building

C. DOCUMENTS CONSIDERED TO BE RELEVANT

| Category* | Citation of document, with indication, where appropriate, of the relevant passages | Relevant to claim No. |
|---|---|---|
| PX | CN 102799706 A (GAO, Lei) 28 November 2012 (28.11.2012) claims 1-10 | 1-10 |
| A | CN 101261616 A (STATE NETWORK WUHAN HIGH VOLTAGE INST. et al.) 10 September 2008 (10.09.2008) description, page 2, and claim 1 | 1-10 |
| A | CN 101272040 A (NORTH CH ELEC POWER SCI RES ACAD CO., LTD. et al.) 24 September 2008 (24.09.2008) the whole document | 1-10 |
| A | CN 1936880 A (STATE NETWORK WUHAN HIGH VOLTAGE INST.) 28 March 2007 (28.03.2007) the whole document | 1-10 |
| A | JP 2008-217541 A (TOKYO ELECTRIC POWER CO., INC.) 18 September 2008 (18.09.2008) the whole document | 1-10 |

☐ Further documents are listed in the continuation of Box C. ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&"document member of the same patent family

| Date of the actual completion of the international search | Date of mailing of the international search report |
|---|---|
| 16 July 2013 (16.07.2013) | 15 August 2013 (15.08.2013) |
| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br>LIU, Qiong<br>Telephone No. (86-10) 82245059 |

Form PCT/ISA /210 (second sheet) (July 2009)

## INTERNATIONAL SEARCH REPORT
Information on patent family members

International application No. PCT/CN2013/075412

| Patent Documents referred in the Report | Publication Date | Patent Family | Publication Date |
|---|---|---|---|
| CN 102799706 A | 28.11.2012 | None | |
| CN 101261616 A | 10.09.2008 | US 2010/0286954 A1 | 11.112010 |
| | | WO 2009129717 A1 | 29.10.2009 |
| CN 101272040 A | 24.09.2008 | None | |
| CN 1936880 A | 28.03.2007 | None | |
| JP 2008-217541 A | 18.09.2008 | None | |

Form PCT/ISA /210 (patent family annex) (July 2009)

## INTERNATIONAL SEARCH REPORT

International application No.
PCT/CN2013/075412

**A. CLASSIFICATION OF SUBJECT MATTER**

G06F 17/50 (2006.01) i
G06F 17/00 (2006.01) i
H02G 13/00 (2006.01) i

Form PCT/ISA /210 (extra sheet) (July 2009)